# EUROPEAN PATENT SPECIFICATION

(11) **EP 4 048 628 B1**
(45) Date of publication and mention of the grant of the patent: **23.09.2026**
(21) Application number: 20807952.5
(22) Date of filing: 21.10.2020
(51) Int. Cl.: H10N 60/01, H10N 60/10, H10D 62/824, B82Y 10/00, H10D 62/10, H10D 30/40, H10D 64/27

(54) **SEMICONDUCTOR-SUPERCONDUCTOR HYBRID DEVICE, ITS MANUFACTURE AND USES**
HALBLEITER-SUPRALEITER-HYBRIDVORRICHTUNG, DESSEN HERSTELLUNG UND VERWENDUNGEN
DISPOSITIF HYBRIDE SEMICONDUCTEUR-SUPRACONDUCTEUR, SA FABRICATION ET UTILISATIONS

(30) Priority: 24.10.2019 US 201916662611
(43) Date of publication of application: 31.08.2022
(73) Proprietor: Microsoft Technology Licensing, LLC, Redmond, WA 98052-6399 (US)
(72) Inventor: WINKLER, Georg Wolfgang, Redmond, Washington 98052-6399 (US); LUTCHYN, Roman Mykolayovych, Redmond, Washington 98052-6399 (US); GARDNER, Geoffrey Charles, Redmond, Washington 98052-6399 (US); KALLAHER, Raymond Leonard, Redmond, Washington 98052-6399 (US); GRONIN, Sergei Vyatcheslavovich, Redmond, Washington 98052-6399 (US); MANFRA, Michael James, Redmond, Washington 98052-6399 (US); KARIMI, Farhad, Redmond, Washington 98052-6399 (US)
(74) Representative: CMS Cameron McKenna Nabarro Olswang LLP
(86) International application number: PCT/US2020/056665
(87) International publication number: WO 2021/081096

(56) References cited:
- WO-A1-2019/001753
- JP-A- S61 275 190
- US-A1- 2015 162 402
- YU LIU ET AL: "Semiconductor - Ferromagnetic Insulator - Superconductor Nanowires: Stray Field and Exchange Field", ARXIV.ORG, CORNELL UNIVERSITY LIBRARY, 201 OLIN LIBRARY CORNELL UNIVERSITY ITHACA, NY 14853, 8 October 2019 (2019-10-08), XP081512164, DOI: 10.48550/arXiv.1910.03364
- KJAERGAARD M ET AL: "Quantized conductance doubling and hard gap in a two-dimensional semiconductor-superconductor heterostructure", ARXIV.ORG, CORNELL UNIVERSITY LIBRARY, 201 OLIN LIBRARY CORNELL UNIVERSITY ITHACA, NY 14853, 6 March 2016 (2016-03-06), XP080687542
- HENRI J SUOMINEN ET AL: "Scalable Majorana Devices", ARXIV.ORG, CORNELL UNIVERSITY LIBRARY, 201 OLIN LIBRARY CORNELL UNIVERSITY ITHACA, NY 14853, 10 March 2017 (2017-03-10), XP080756123
- P. KROGSTRUP ET AL: "Epitaxy of semiconductor-superconductor nanowires", NATURE MATERIALS, vol. 14, no. 4, 1 April 2015 (2015-04-01), London, pages 400 - 406, XP055458664, ISSN: 1476-1122, DOI: 10.1038/nmat4176

## Description

### BACKGROUND

Topological quantum computing is based on the phenomenon whereby non-abelian anyons, in the form of "Majorana zero modes" (MZMs), can be formed in regions where a semiconductor is coupled to a superconductor. A non-abelian anyon is a type of quasiparticle, meaning not a particle per se, but an excitation in an electron liquid that behaves at least partially like a particle. An MZM is a particular bound state of such quasiparticles. Under certain conditions, these states can be formed close to the semiconductor-superconductor interface in a nanowire formed from a length of semiconductor coated with a superconductor. When MZMs are induced in the nanowire, it is said to be in the "topological regime". To induce this requires a magnetic field, conventionally applied externally, and also cooling of the nanowire to a temperature that induces superconducting behaviour in the superconductor material. It may also involve gating a part of the nanowire with an electrostatic potential.

By forming a network of such nanowires and inducing the topological regime in parts of the network, it is possible to create a quantum bit (qubit) which can be manipulated for the purpose of quantum computing. A quantum bit, or qubit, is an element upon which a measurement with two possible outcomes can be performed, but which at any given time (when not being measured) can in fact be in a quantum superposition of the two states corresponding to the different outcomes.

To induce an MZM, the device is cooled to a temperature where the superconductor (e.g. Aluminium, Al) exhibits superconducting behaviour. The superconductor causes a proximity effect in the adjacent semiconductor, whereby a region of the semiconductor near the interface with the superconductor also exhibits superconducting properties. I.e. a topological phase behaviour is induced in the adjacent semiconductor as well as the superconductor. It is in this region of the semiconductor where the MZMs are formed.

Another condition for inducing the topological phase where MZMs can form is the application of a magnetic field in order to lift the spin degeneracy in the semiconductor. Degeneracy in the context of a quantum system refers to the case where different quantum states have the same energy level. Lifting the degeneracy means causing such states to adopt different energy levels. Spin degeneracy refers to the case where different spin states have the same energy level. Spin degeneracy can be lifted by means of a magnetic field, causing an energy level spilt between the differently spin-polarized electrons. This is known as the Zeeman effect. The g-factor refers to the coefficient between the applied magnetic field and the spin splitting. Typically, the magnetic field is applied by an external electromagnet. However, US 16/246287 has also disclosed a heterostructure in which a layer of a ferromagnetic insulator is disposed between the superconductor and semiconductor in order to internally apply the magnetic field for lifting the spin degeneracy, without the need for an external magnet. Examples given for the ferromagnetic insulator included compounds of heavy elements in the form of EuS, GdN, Y₃Fe₅O₁₂, Bi₃Fe₅O₁₂, YFeO₃, Fe₂O₃, Fe₃O₄, GdN, Sr₂CrReO₆, CrBr₃/CrI₃, YTiO₃ (the heavy elements being Europium, Gadolinium, Yttrium, Iron, Strontium and Rhenium).

Inducing MZMs typically also requires gating the nanowire with an electrostatic potential. However, US 16/120433 has also disclosed a structure which is capable of exhibiting topological behaviour including MZMs without the need for gating. In this case the nanowires have a full shell of superconductor all the way around the perimeter of the nanowire, which obviates the need for gating.

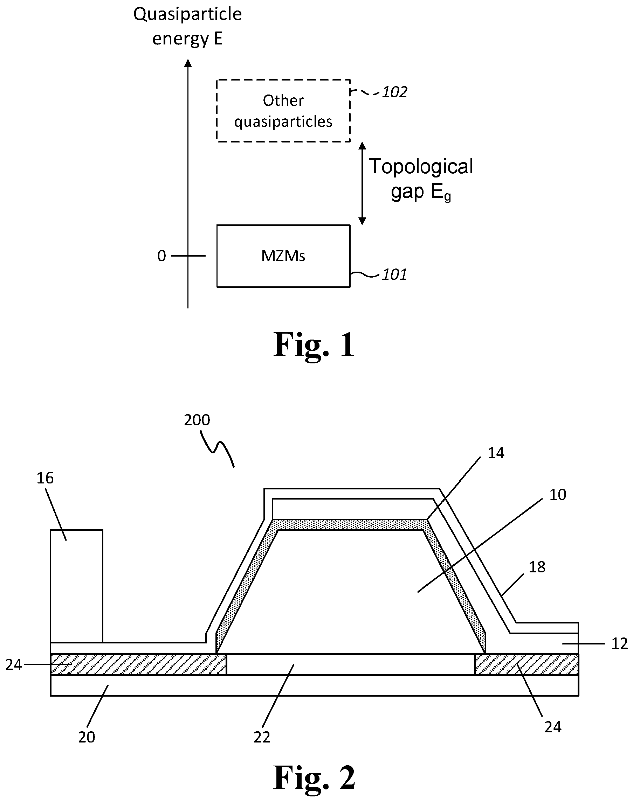

As illustrated in Fig. 1, in order to create good quality devices in which the MZMs are long-lived, it is preferable to have a large topological gap E_{g}. A material in the topological phase (whether a superconductor or a region of proximity-induced superconductivity in a semiconductor) exhibits distinct energy bands: a lower band 101 and an upper band 102. The lower band 101 is a band where the quasiparticle energy E falls in a lower range, and the upper band (or "excitation band") 102 is a band of higher quasiparticle energy. The topological gap E_{g} is an energy window between the upper and lower bands 101, 102 where no quasiparticles can exist due to the quantized (discrete) nature of the quasiparticle energy levels. The lower band 101, upper band 102 and topological gap E_{g} are analogous to the valence band, conduction band and band gap for electrons in a semiconductor. In the upper, excitation, band 102 the quasiparticles can propagate freely through the superconductor (or proximity-induced region in a semiconductor), analogous to the electrons in the valence band in a semiconductor.

The Majoranas, whose states form the MZMs, form the lower band 101. The Majoranas are part of the computational space, i.e. the properties of the system being exploited for the quantum computing application in question. In other words, the MZMs are the operating elements of the qubit. On the other hand, the particle-like excitations (quasiparticles) in the upper band 102 are not part of the computational space. If these quasiparticles cross the topological energy gap E_{g} into the lower band 101 due to thermal fluctuations, then they will destroy at least some of the MZMs. This is sometimes referred to as "poisoning" the MZMs. The gap E_{g} provides protection for the MZMs against such poisoning. The probability of a quasiparticle existing in the upper band and crossing the gap E_{g} from the upper to the lower band is proportional to *e*^{*-E^{g}*/*kT*} where T is temperature and k is the Boltzmann constant. Hence the larger the topological gap, the more protection is afforded to the MZMs against poisoning from the harmful quasiparticles in the upper band 102.

A more detailed treatment of the theory of operation of hybrid semiconductor-superconductor devices is provided by Stanescu et al (Physical Review B 84, 144522 (2011)) and Winkler et al (Physical Review B 99, 245408 (2019)).
M. Kjaergaard et al., "Quantized conductance doubling and hard gap in a two-dimensional semiconductor-superconductor heterostructure", p. 1-10, 2016, describes how the prospect of coupling a two-dimensional (2D) semiconductor heterostructure to a superconductor opens new research and technology opportunities, including fundamental problems in mesoscopic superconductivity, scalable superconducting electronics, and new topological states of matter. For instance, one route toward realizing topological matter is by coupling a 2D electron gas (2DEG) with strong spin-orbit interaction to an s-wave superconductor. Previous efforts along these lines have been hindered by interface disorder and unstable gating. Here, we report measurements on a gateable InGaAs/InAs 2DEG with patterned epitaxial Al, yielding multilayer devices with atomically pristine interfaces between semiconductor and superconductor. Using surface gates to form a quantum point contact (QPC), the authors find a hard superconducting gap in the tunneling regime, overcoming the soft-gap problem in 2D superconductor-semiconductor hybrid systems. With the QPC in the open regime, we observe a first conductance plateau at 4e^2/h, as expected theoretically for a normal-QPC-superconductor structure. The realization of a hard-gap semiconductor-superconductor system that is amenable to top-down processing provides a means of fabricating scalable multicomponent hybrid systems for applications in low-dissipation electronics and topological quantum information.
H.J. Suominen et al., "Scalable Majorana Devices", p.1-13, 2017, describes how Majorana zero modes have received widespread attention due to their potential to support topologically protected quantum computing. Emerging as zero-energy states in one-dimensional semiconductors with induced superconductivity, Zeeman coupling, and spin-orbit interaction, Majorana modes have been primarily investigated in individual InSb or InAs nanowires, including recently realized epitaxial hybrid nanowires. Tests of non-Abelian statistics of Majoranas involve braiding or interferometric measurement, requiring branched geometries, which are challenging to realizing using nanowire growth. Scaling to large networks using arrays of assembled nanowire also appears difficult.
P. Krogstrup et al., "Epitaxy of semiconductor-superconductor nanowires", vol 14, p. 400-406, 2015, describes how controlling the properties of semiconductor/metal interfaces is a powerful method for designing functionality and improving the performance of electrical devices. Recently semiconductor/superconductor hybrids have appeared as an important example where the atomic scale uniformity of the interface plays a key role for the quality of the induced superconducting gap. Here the authors present epitaxial growth of semiconductor-metal core-shell nanowires by molecular beam epitaxy, a method that provides a conceptually new route to controlled electrical contacting of nanostructures and for designing devices for specialized applications such as topological and gate-controlled superconducting electronics. Our materials of choice, InAs/Al, are grown with epitaxially matched single plane interfaces, and alternative semiconductor/metal combinations allowing epitaxial interface matching in nanowires are discussed.
JP 61-275190 A describes the PURPOSE: To obtain the titled crystal layer having excellent electrical and optical characteristics by forming a specified crystal layer through an InP crystal layer formed on an InP crystal substrate by the molecular beam epitaxial growth method. CONSTITUTION: An InxGal-x-yAlyAs crystal layer (10≤x≤0.9, 0.1≤7<1 and x+y=1) is formed on an InP crystal substrate by the molecular beam epitaxial growth method in the molecular beam epitaxial growth method of an InGaAlAs crystal layer. In the method, an InP crystal layer is formed on the InP crystal substrate by the molecular beam epitaxial growth method, before the InxGal-x-yAlyAs crystal layer is formed on the InP crystal substrate. In the molecular beam epitaxial growth method of the InGaAlAs crystal layer, the InP crytal layer is formed in ≥0.3µ thickness and hence an InP crystal layer having crystal defects up to the surface is not formed.
US 2015/0162402 A1 describes that a photomask has a mask blank and a light shielding film formed on the mask blank. The light shielding film includes a plurality of opening traces extending in a first direction. An end of a first opening trace in the first direction and an end of a second opening trace in the first direction are in different positions in the first direction. The second opening trace adjoins the first opening trace.
WO 2019/001753 A1 describes how a mixed semiconductor-superconductor platform is fabricated in phases. In a masking phase, a dielectric mask is formed on a substrate, such that the dielectric mask leaves one or more regions of the substrate exposed. In a selective area growth phase, a semiconductor material is selectively grown on the substrate in the one or more exposed regions. In a superconductor growth phase, a layer of superconducting material is formed, at least part of which is in direct contact with the selectively grown semiconductor material. The mixed semiconductor- superconductor platform comprises the selectively grown semiconductor material and the superconducting material in direct contact with the selectively grown semiconductor material.

Yu Liu et al., "Semiconductor-Ferromagnetic Insulator-Superconductor Nanowires: Stray Field and Exchange Field", doi: 10.48550/arXiv.1910.03364, (08.10.2019) discloses a ferromagnetic insulator layer between a semiconductor layer and a superconductor layer, but not in combination with a barrier layer also located between a semiconductor layer and a superconductor layer.

### SUMMARY

The invention is set out in the appended set of claims.

It would be desirable to provide a semiconductor-superconductor hybrid device with a large topological gap, more particularly a topological gap which is as close as possible to the theoretical limit.

A semiconductor-superconductor hybrid device comprises a semiconductor, a superconductor, and a barrier between the superconductor and the semiconductor. The device is configured to enable energy level hybridisation between the semiconductor and the superconductor. The barrier is configured to increase a topological gap of the device. The barrier allows for control over the degree of hybridisation between the semiconductor and the superconductor. Further aspects provide a quantum computer comprising the device, a method of manufacturing the device, and a method of inducing topological behaviour in the device.

### BRIEF DESCRIPTION OF THE DRAWINGS

To assist understanding of embodiments of the present disclosure and to show how such embodiments may be put into effect, reference is made, by way of example only, to the accompanying drawings in which:
Fig. 1 is a diagram illustrating the concept of a topological gap;
Fig. 2 is a cross-sectional view of a first example of a semiconductor-superconductor hybrid device;
Fig. 3 is a plot showing Δ/Δ₀ (a measure of induced superconducting gap) against Γ/Δ₀ (a measure of coupling strength) for: a) a semiconductor at zero magnetic field in the non-topological regime; b) an InSb semiconductor in the topological regime; and c) an InAs semiconductor in the topological regime;
Fig. 4 is a plot showing the experimentally determined band offset between an In₁₋ₓAlₓAs semiconductor and an aluminium superconductor as a function of x;
Figs. 5a and 5b are heat maps showing maximum topological gap as a function of α (a measure of spin-orbit coupling strength) and x for two semiconductor-superconductor hybrid devices having different barrier thicknesses;
Fig. 6a is a heat map illustrating potential differences at various positions in one illustrative semiconductor-superconductor hybrid device, omitting data for the sub-structure below the device and space above the device (cross-hatched areas);
Fig. 6b is a plot showing potential difference as a function of distance d along line a of Fig. 6a;
Fig. 7a is a heat map illustrating potential differences at various positions in another illustrative semiconductor-superconductor hybrid device, omitting data for the sub-structure below the device and space above the device (cross-hatched areas); regarding the voltage scale;
Fig. 7b is plot showing potential difference as a function of distance d along line a of Fig. 7a;
Fig. 8 is a cross-sectional view of a second example of a semiconductor-superconductor hybrid device;
Fig. 9 is a flowchart of a method of manufacturing a semiconductor-superconductor hybrid device; and
Fig. 10 is a flowchart of a method of using a semiconductor-superconductor hybrid device.

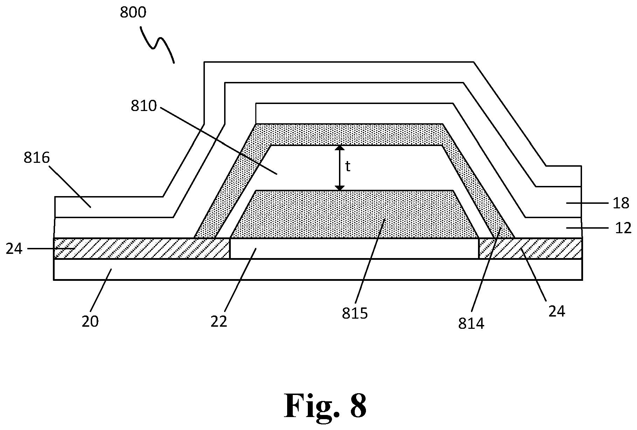

Figs. 2 and 8 are schematic, and are not to scale. The relative proportions of components shown in these Figs. may be exaggerated for ease of representation.

### DETAILED DESCRIPTION

As used herein, the verb 'to comprise' is used as shorthand for 'to include or to consist of'. In other words, although the verb 'to comprise' is intended to be an open term, the replacement of this term with the closed term 'to consist of' is explicitly contemplated, particularly where used in connection with chemical compositions.

Directional terms such as "top", "bottom", "left", "right", "above", "below", "horizontal" and "vertical" are used herein for convenience of description and relate to the semiconductor-superconductor hybrid device in the orientation shown in Figs. 1 and 2. For the avoidance of any doubt, this terminology is not intended to limit the orientation of the device in an external frame of reference.

As used herein, the term "superconductor" refers to a material which becomes superconductive when cooled to a temperature below a critical temperature, T_{c}, of the material. The use of this term is not intended to limit the temperature of the device.

The term "coupling" in the context of the present disclosure refers in particular to the hybridisation of energy levels.

A "nanowire" as referred to herein is an elongate member having a nano-scale width, and a length-to-width ratio of at least 100, or at least 500, or at least 1000. A typical example of a nanowire has a width in the range 10 to 500 nm, optionally 50 to 100 nm or 75 to 125 nm. Lengths are typically of the order of micrometers, e.g. at least 1 µm, or at least 10 µm. In the present context, the nanowires are typically formed of a semiconductor material.

A "band offset" between a semiconductor and a metal is a difference in energy between the conductance band of the semiconductor and the Fermi level of the metal.

A first example of a semiconductor-superconductor hybrid device 200 will now be explained with reference to Figure 2.

The semiconductor-superconductor hybrid device 200 includes a semiconductor 10, a barrier 14 arranged over the semiconductor, and a superconductor 12 arranged over the barrier 14. The semiconductor 10 and the superconductor 12 are separated from one another by the barrier 14.

In this example, the semiconductor 10 is arranged as a nanowire. In the present example, semiconductor 10 is indium monoarsenide, InAs. Barrier 14 covers top and side surfaces of the semiconductor 12.

Superconductor 12 is in the form of a layer over a top surface and a first side surface of the nanowire. In the present example, superconductor layer 12 is a layer of aluminium. Winkler *et al* (cited above) report that aluminium couples strongly to InAs, and that the strength of the coupling may vary depending on the thickness of the superconductor layer. The thickness may be in the range 4 to 10 nm, for example.

Although the present example relates to an indium monoarsenide semiconductor and an aluminium superconductor, the principles of the present disclosure are applicable to other semiconductor-superconductor pairs.

The semiconductor 10 and the superconductor 12 allow for useful topological behaviour (i.e., useful excitations such as Majorana zero modes) to be induced in the device during operation. Hybridisation of energy levels of the semiconductor 10 with those of the superconductor 12 allows for such behaviour. Barrier 14 may provide an electrical barrier between the semiconductor 10 and the superconductor 12. Barrier 14 may for example control the degree of hybridisation. As will be explained in more detail subsequently, by selecting the physical thickness of the barrier 14 and the composition of the barrier 14 (which determines a band offset between the barrier 14 and the superconductor 12) a topological gap of the device may be optimized.

A protective layer 18 covers an upper surface of device 200. This layer may protect the device from oxidation, particularly during manufacturing processes. The protective layer 18 may additionally serve as an electrical insulator for preventing flow of current from a gate electrode 20 into the device. The material which forms the protective layer 18 may be any of the various protective materials known in the field of semiconductor manufacture. Protective layer 18 is typically of a dielectric, such as hafnium oxide.

The device 200 further includes a gate electrode 16 which, in this example, is arranged to one side of the nanowire. The gate electrode is arranged on protective layer 18, and is spaced from the nanowire by an air gap. In this configuration, both the protective layer 18 and the air gap serve to prevent a flow of current from the gate electrode 16 into the superconductor 10 and semiconductor 12.

Gate electrode 16 is for applying an electrostatic field to the semiconductor layer 10. Providing such gating allows for control over the degree of energy level hybridization between the semiconductor and superconductor. This may be useful for inducing excitations in the device.

The configuration of the gate electrode 16 is not particularly limited provided that the gate electrode is capable of gating the device. The gate electrode may be in any appropriate position in the device: e.g. to one side of the nanowire as in the present example; over the nanowire as in the second example described below; or under the nanowire. The gate electrode 16 may be formed of any suitable material. The gate electrode is typically not superconductive. The gate electrode 16 may be of gold, or a gold-titanium alloy, for example.

Device 200 is arranged on a sub-structure. The sub-structure provides physical support for the device. The form of the sub-structure has little, if any, impact on the operation of the device. In this example, the sub-structure comprises a substrate 20, with a buffer 22 and a mask 24 arranged on the substrate 20.

The nature of substrate 20 is not particularly limited. The substrate may be any of the various substrates used in the manufacture of semiconductor devices. Indium phosphide is one illustrative example of a useful substrate material.

Mask 24 of this example comprises a silicon oxide. Various other masks may be used, for example, silicon nitride. Buffer 22 comprises InGaAs. The device of the present example is manufactured by selective area growth. Mask 24 and buffer 22 are used during one example of a selective area growth process. The mask 24 and buffer 22 may remain in the finished device without negative effect, but are not essential to the operation of the device.

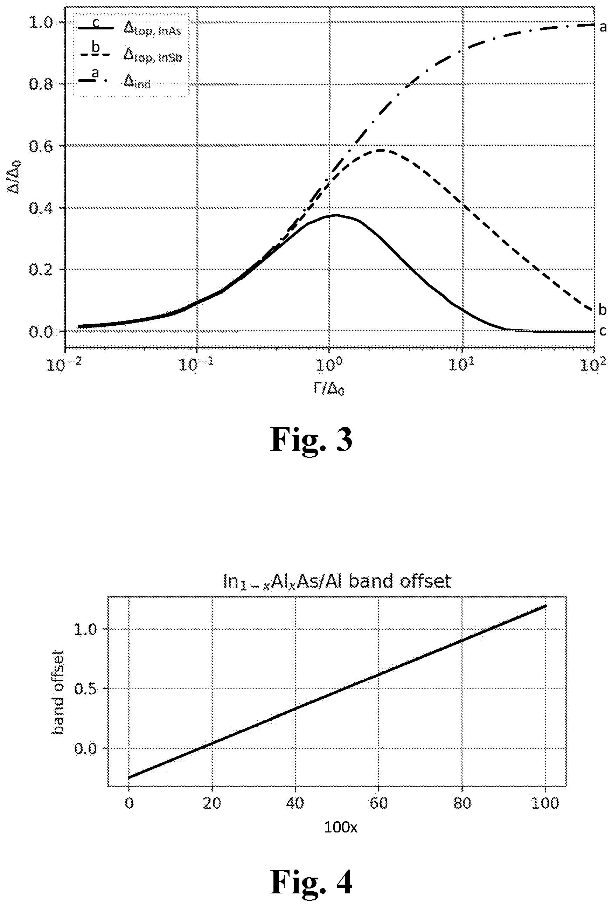

The structure and function of the barrier 14 will now be explained with reference to Figs. 3 to 8.

Barrier 14 serves to adjust the degree of coupling, in other words, the degree of energy level hybridisation, between the semiconductor 10 and the superconductor 12. By controlling the degree of coupling, the topological gap of the device may be optimized. This principle is illustrated in Fig. 3.

Fig. 3 shows a plot of Δ/Δ₀ (y axis), which is a measure of the induced superconducting gap of a system, as a function of Γ / Δ₀ (x axis), which provides a measure of coupling strength. Δ is the effective gap; Δ₀ is the value of the superconducting gap inside the superconductor; and Γ is the coupling factor. For a hybrid system, the coupling factor provides a measure of the degree of coupling of a semiconductor wavefunction with a superconductor wavefunction.

Three curves are showing the induced superconducting gap are shown: (a) a semiconductor at zero magnetic field in the non-topological regime; (b) an InSb semiconductor in the topological regime; and (c) an InAs semiconductor in the topological regime

Energy gap in a hybrid system cannot exceed the energy gap in a purely superconductive system. Curves b and c are thus bounded by curve a.

Curves b and c have defined maxima. The topological gap in hybrid systems based on these materials increases up to a certain point as the level of coupling to the superconductor increases. However, beyond a certain limit, the hybrid energy states have too much superconductive character, and the topological gap drops away. The exact position and height of these maxima varies depending on the semiconductor material chosen.

In the hybrid semiconductor-superconductor devices provided herein, the barrier moderates the degree of coupling between the semiconductor and the superconductor. In other words, the barrier controls the position along the x axis of Fig. 3. By providing a barrier with selected properties, a device having an optimized topological gap may be constructed.

Both the physical thickness of the barrier and its composition contribute to its effects.

For a given barrier layer composition, increasing the barrier thickness lowers the coupling between the semiconductor and the superconductor.

For a given barrier thickness, increasing the band offset between the barrier and the superconductor (i.e., the energy spacing between the Fermi level of the superconductor and the conduction band of the barrier) lowers the coupling between the semiconductor and the superconductor. In other words, increasing the height of the potential step of the barrier lowers the coupling between the semiconductor and the superconductor. The band offset is determined by the properties of the materials used, and may be controlled by varying the composition of the barrier, for example.

Adjusting one or both of the barrier composition and barrier thickness thus allows for control over coupling, and control over topological gap.

The Fig. 2 device has a barrier comprising a material of Formula IIa:

In₁₋ₓAlₓAs

where x is in the range of 0.05 to 1. Fig. 3 illustrates the relationship between band offset to an aluminium superconductor x for materials according to this formula. As may be seen, the band offset increases as x increases.

As the band offset increases, the barrier thickness for achieving maximum topological gap reduces. In the case where x=1, i.e., when the barrier comprises AlAs, the optimum layer thickness is expected to be very thin, e.g. 1 to 10 layers of atoms. The reliable manufacture of such thin layers may be difficult. It is useful to select a value of x which is relatively low, e.g. less than or equal to 0.4, or less than or equal to 0.3.

Varying x also influences the lattice constant of the material. It is useful for the barrier 12 to have a lattice constant which is similar to that of the semiconductor 10. This may, for example, facilitate epitaxial growth of the barrier 12 on the semiconductor 10 during manufacture. In the present example, the semiconductor comprises InAs and selecting a value of x which is less than or equal to 0.4, or less than or equal to 0.3. For these values, the lattice constants of the materials of Formula IIa are close to that of InAs.

It may be preferable for *x* to be selected such that the band offset to the superconductor is positive. Small negative band offsets are tolerated. Typically, for materials of Formula IIa, *x* is at least 0.1.

Particularly preferred values for *x* in the context of the present example are in the range 0.15 to 0.2.

The thickness of the barrier 12 is generally in the range 2 nm to 30 nm, for example, 5 to 10 nm. As previously explained, the optimum thickness for providing the maximum topological gap will vary depending on the particular materials chosen.

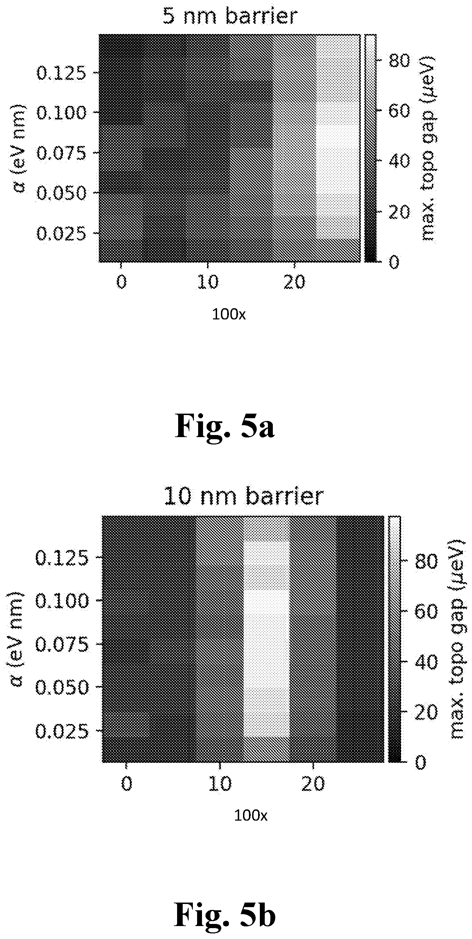

Figs. 5a and 5b illustrate the interplay between barrier thickness and barrier composition for the example device described with reference to Fig. 2. These Figs. show the results of computational investigations of topological gap as a function of the alpha value of a system (a measure of the degree of spin-orbit coupling) and the variable x in Formula IIa. The topological gaps in such systems are illustrated as heat maps: the darker the region, the lower the topological gap.

Fig. 5a illustrates topological gaps in a device having a 5 nm thick barrier. The maximum topological gap is observed when x has a value of about 0.25.

Fig. 5b shows a plot for a device having a 10 nm barrier. In this example, the maximum topological gap is obtained when x is about 0.15.

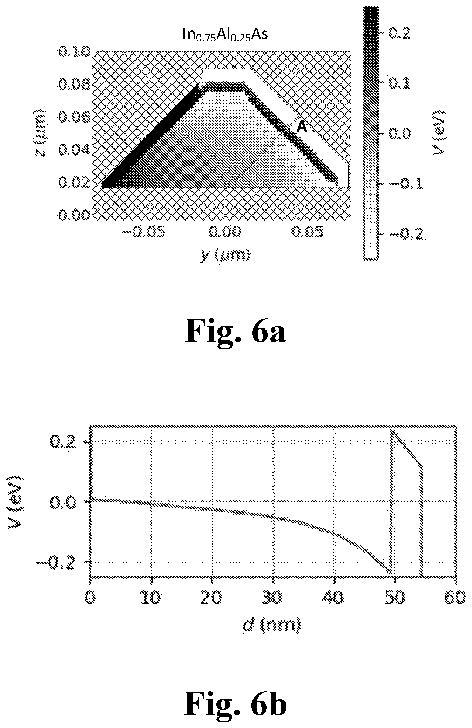

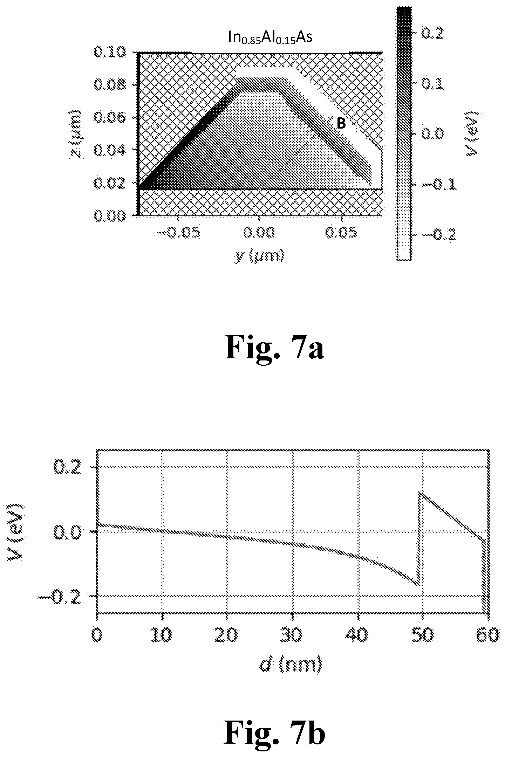

Further data to illustrate the relationship between band offset (determined by the selection of materials) and barrier thickness are shown in Figs. 6 and 7.

Figs. 6a and 6b illustrate potential differences within a device having the general structure described with reference to Fig. 2. More specifically, the energy of the bottom of the conduction band relative to the Fermi level is illustrated. This particular device includes a 5 nm thick barrier comprising In_{0.75}Al_{0.25}As.

Fig. 6a shows a heat map of potential difference as a function of position within the device. The heat map is annotated with a line A extending from the base of the semiconductor at coordinates (0.00, 0.00) to the upper surface of the superconductor. The cross-hatched areas correspond to the sub-structure of the device and the space surrounding the device; data in these areas is omitted for clarity.

Fig. 6b illustrates the voltage in the device against distance d along line A. The observed potential difference becomes progressively more negative closer to the superconductor. At d = 50 nm, line A passes through the barrier. An abrupt increase in potential difference is observed, illustrating that the barrier provides electrical insulation between the semiconductor and the superconductor. The observed potential difference drops to a strongly negative value at the superconductor (d = 55 nm).

Figs. 7a and 7b are similar to Figs. 6a and 6b, but show results for a device having a thicker, 10 nm, barrier and a lower band offset between the barrier and the superconductor arising from the use of a different barrier composition, In_{0.85}Al_{0.15}As.

Fig. 7a shows a heat map of potential difference as a function of position within the device, and is annotated with a line B extending from the base of the semiconductor through the barrier to the superconductor. Fig. 7b shows the potential differences observed along line A.

The plot shown in Fig. 7b has a similar overall form to that of Fig. 6b: voltage gradually becomes more negative moving through the semiconductor toward the superconductor. At a distance d along line B of 50 nm, the line reaches the barrier. There is again an abrupt increase in potential difference at the barrier. The increase is however to a lesser extent than that shown in Fig. 6b, as a consequence of the lower band offset in the present example. The width of the area of increased voltage is greater, however, due to the increased barrier thickness compared to the Fig. 6b example.

The area under the potential difference curve in Figs. 5b and 6b is therefore determined by the composition (which defines the height of the barrier in terms of band offset) and the physical thickness of the barrier. Setting this area to be greater than 0 may provide an energy barrier useful for optimizing coupling, and thus optimizing topological gap.

Although the above-described examples relate to particular combinations of semiconductor, superconductor, and barrier materials, the underlying principles of the present disclosure are widely applicable and may be generalised to other combinations of materials. One of skill in the art will be able to arrive at further devices based on the details provided herein.

Although the Fig. 2 example uses aluminium as the superconductor, any alternative superconductor could be used. The superconductor is typically an s-wave superconductor. Examples of s-wave superconductors include indium, tin and lead. The device structure may be varied depending on the superconductor chosen. For example, lead has a larger superconductive gap than aluminium. For a given barrier composition, optimum barrier thickness will be greater for a lead-based device than an aluminium based-device. At the same time, for a given barrier thickness, the optimum band offset would be larger for the lead-based device.

The Fig. 2 example uses a barrier layer having a composition of Formula IIa.

Alternative barrier layer compositions may be used. One useful class of materials are those of Formula IIb:

In₁₋ₓGaₓAs

where x is in the range 0.05 to 1, e.g. in the range 0.1 to 0.4 or 0.15 to 0.3. For a given value of x, a composition of Formula IIb will have a lower band offset than a composition of Formula IIa. Barrier thicknesses are therefore adjusted upward when using a composition of Formula IIb. For example, barrier thicknesses when using a Formula IIb material are typically at least 3 nm, e.g. in the range 3 to 20 nm.

The use of still other barrier materials is possible.

The Fig. 2 device uses InAs as the semiconductor. Alternative semiconductors may be used. Particular examples of alternative semiconductors include those of Formula I:

InAs_{y}Sb_{1-y} (Formula I)

where y is in the range 0 to 1. Put differently, as alternatives to indium monoarsenide (y=1), the semiconductor may comprise indium antimonide (y=0), or a ternary mixture comprising 50% indium on a molar basis and variable proportions of arsenic and antimony (0 < y <1).

Indium monoarsenide, InAs, has been found to have good handling properties during manufacture of the device, and provides devices with good performance. Indium antimonide, InSb, provides further improvements to device performance but may be more difficult to use during manufacturing processes. The ternary mixtures have intermediate properties between those of the binary compounds InAs and InSb. Improvements in device performance compared to InSb may be observed when y is in the range 0 to 0.7, or 0.01 to 0.7. Values of y in the range 0.20 to 0.45 may provide a particularly good balance of device performance and handling properties.

Fig. 3 illustrates that InSb (curve b) has different properties to InAs (curve c). The properties of the ternary mixtures of Formula I are expected to be somewhere in between curves b and c if y is in the range 0.7 to 1.0 and enhanced compared to InSb if y is in the range 0.01 to 0.7. Fig. 3 shows that, compared to InAs, InSb has an optimum topological gap at a higher level of coupling to the semiconductor. Thus, topological gap in an InSb-based device may be optimized by selecting a barrier which is thinner than in a comparable InAs-based device; and/or by selecting a barrier material with a smaller band offset.

Still other semiconductors may be used, with the configuration of the barrier being adjusted appropriately based on the principles described herein.

Although Fig.2 shows that the barrier extends over the top and both side surfaces of the semiconductor, this is not essential so long as the barrier is present in at least the regions where the superconductor overlies the semiconductor.

The substructure and gate electrode configuration may be freely varied.

A second example of a semiconductor-superconductor hybrid device 800 will now be described in terms of its differences to the first example, and with reference to Fig. 8. Like reference signs are used for like elements.

The second example differs from the first principally in that the semiconductor 810 is arranged in a sandwich structure between an insulating component 815 and a barrier 814, and in that the device is top-gated rather than side-gated.

Insulating component 815 is arranged on the substructure 20, 22, 24 of the device 800. The substructure 20, 22, 24 has the same configuration as in the first example. Semiconductor component 810 is arranged over the insulating component 815. The top and sides of semiconductor 810 are covered by barrier 814.

Insulating component 815 may conveniently be formed of the same material as the barrier 814, although any insulating material may be used. Insulating component 815 may be formed of a semiconductor material, but its semiconducting properties are not used in the context of the present device. There is a large difference (e.g., at least 30 meV, optionally at least 50 meV) in energy between the conduction band of semiconductor and the conduction band of insulating component. When the device is in use, electrons are trapped in semiconductor layer 810 and do not escape into the insulating component.

Semiconductor 810 has a defined thickness, t. The thickness t may, for example, be in the range 5 nm to 50 nm, optionally 10 to 40 nm, further optionally 20 to 30 nm. Varying the thickness of the semiconductor layer may vary the number of occupied energy levels (sub-bands) at the interface between the semiconductor and the superconductor. This is useful for tuning the quantum mechanical behaviour of the device.

The thickness of semiconductor layer may be optimised based on the properties of the materials selected to maximize the topological gap. In one particular example where the band offset between the conductance band of the semiconductor and that of the insulating component and barrier is about 50 meV and the alpha value for the device is 0.1 eV nm, a semiconductor thickness of about 25 nm is particularly preferred. Simulation is one useful method for determining an optimum semiconductor layer thickness for a given device.

The tops and corners of semiconductor devices in general are difficult to manufacture reproducibly. Small variations in device structure may be present in these areas. Likewise, the substructure may have small variations. Spacing the semiconductor away from the areas may allow greater control over its geometry.

Fig. 8 further shows that device 800 is top-gated. Gate electrode 816 is arranged over the top of the device. Protective layer 18 is arranged between the gate electrode 816 and the remaining components of the device, and acts to prevent flow of current from the gate electrode 816 to the remaining components.

A bottom-gated configuration (not illustrated) is also contemplated. In such a configuration, the gate electrode is arranged below the sub-structure, and the sub-structure acts to prevent current flow from the gate electrode into the remaining components of the device.

According to the invention, any of the devices provided herein includes a layer of ferromagnetic insulator configured to apply a magnetic field to the semiconductor and superconductor, for lifting spin degeneracy. The layer of ferromagnetic insulator may, for example, be arranged below the superconductor, e.g. between the superconductor and the barrier. The ferromagnetic insulator layer may comprise a material selected from: EuS, GdN, Y₃Fe₅O₁₂, Bi₃Fe₅O₁₂, YFeO₃, Fe₂O₃, Fe₃O₄, GdN, Sr₂CrReO₆, CrBr₃/CrI₃, and YTiO₃. US 16/246287, provides further description of a ferromagnetic insulator layer.

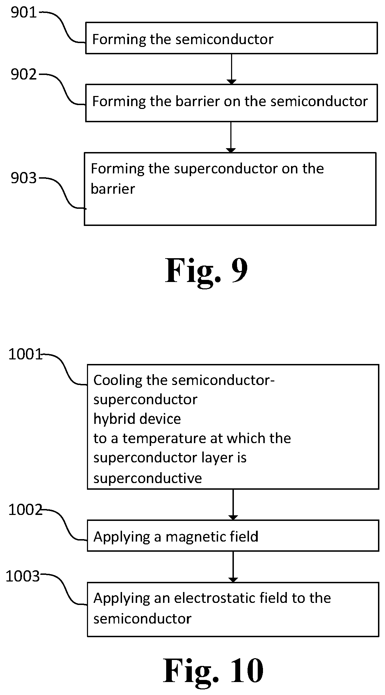

Fig. 9 is a flowchart outlining steps of an illustrative method for manufacturing a semiconductor-superconductor hybrid device as described herein.

The method generally comprises manufacturing the semiconductor, then the barrier, and then the superconductor. At block 901, the semiconductor is formed. At block 902, a barrier is formed on the semiconductor. At block 903, a superconductor is formed on the barrier so as to enable energy level hybridisation between the semiconductor layer and the superconductor layer. Additional components may be formed between any of steps 901 to 903, or in subsequent steps. In examples where the device includes an insulator, the insulator is formed before the semiconductor.

The specific techniques used to form the various components are not particularly limited, and may be selected as appropriate. Various suitable techniques will be known to the person skilled in the art. Examples include selective area growth; chemical vapour deposition; lithography; and the like. Techniques which result in epitaxial growth of components may allow for good contact between those components, and may be preferred.

Fig. 10 is a flowchart outlining an illustrative method of using a semiconductor-superconductor hybrid device as provided herein.

Use of the device typically involves inducing topological behaviour, i.e., a particular type of electron excitation, into the device. This is made possible by energy level hybridisation between the semiconductor and the superconductor, creating bands which have a mixture of semiconducting and superconducting character. Such excitations may be useful in quantum computing. For example, they may be used to encode a quantum bit (also referred to as a qubit). Without wishing to be bound by theory, it is believed that the semiconductor-superconductor hybrid devices provided herein generate Majorana zero modes.

At block 1001, the semiconductor-superconductor hybrid device is cooled to a temperature at which the superconductor layer is superconductive. Put differently, the device is cooled to a temperature below the critical temperature T_{c} of the superconductor layer such that the layer displays superconductive behaviour (e.g., behaves as if it as zero resistance). Such temperatures are generally of the order of tens of Kelvin or below. T_{c} depends on the material used, and may in certain cases be influenced by the thickness of the material. The temperature may be selected as appropriate.

At block 1002, a magnetic field is applied to the semiconductor layer. The magnetic field lifts spin degeneracy in the device, thereby changing the energy band structure at the interface between the semiconductor and the superconductor. The magnetic field is typically applied externally, for example using an electromagnet.

At block 1003, an electrostatic field is applied to the semiconductor layer. Typically, the semiconductor-superconductor hybrid device includes a gate electrode, and the gate electrode is used to apply the electrostatic field. In alternatives, the electrostatic field may be externally applied. The electrostatic field may vary the degree of energy level hybridisation between the semiconductor and the superconductor. For example, hybridisation may be decreased when electrons are drawn away from the superconductor by the electrostatic field. This may make the low-energy states - i.e., the states of interest - more susceptible to the magnetic field. This may in tum allow a topological phase at smaller magnetic fields, leading to enhanced properties for quantum computation.

It will be appreciated that the above embodiments have been described by way of example only.

More generally, according to one aspect disclosed herein, there is provided a semiconductor-superconductor hybrid device, comprising: a semiconductor; a superconductor; and a barrier between the superconductor and the semiconductor; wherein the device is configured to enable energy level hybridisation between the semiconductor and the superconductor; and wherein the barrier is configured to increase a topological gap of the device.

The semiconductor-superconductor hybrid device may further comprise a gate electrode configured to apply an electrostatic field to the semiconductor. Electrostatic gating may be useful for inducing topological behaviour in the device. The arrangement of the gate electrode is not particularly limited. The device may be top-, side-, or bottom gated. In top- and side-gated configurations, a dielectric for preventing flow of current is typically provided between the gate electrode and other components of the device. In the side-gated configuration, the dielectric may comprise an air gap. In bottom-gated configurations, the gate electrode is arranged below a substrate of the device, such that the substrate acts as a dielectric.

The semiconductor may comprise a material of Formula I:

InAs_{y}Sb_{1-y}

where y is in the range 0 to 1. For example, y may be in the range 0.8 to 1. Particularly preferably, the semiconductor may comprise InAs. Although the principles underlying the present disclosure are applicable to a very broad range of semiconductors, this class has been investigated in particular.

The superconductor may comprise aluminium. For example, the superconductor may be an aluminium layer having a thickness in the range 4 to 10 nm. More generally, any superconductor may be used, in particular, any s-wave superconductor. One such example is lead. Other examples are indium and tin.

The barrier may have a thickness and composition selected to adjust energy level hybridisation between the semiconductor and superconductor. As explained hereinabove, adjusting the degree of hybridisation allows for optimization of the topological gap of the device.

The barrier may comprise a high band gap semiconductor. A material may be regarded as having a "high band gap" when it has a conductance band with an energy level that is at least 30 meV higher, preferably 50 meV higher, more preferably at least 100 meV higher, than a conductance band of the material used as the semiconductor of the hybrid device.

The barrier may comprise a material of Formula II:

In₁₋ₓAₓAs

wherein A is Al or Ga; wherein x is in the range of 0.05 to 1. In particular, A may be Al. x is typically in the range 0.05 to 0.4. For example, x may be in the range of 0.1 to 0.25. The range 0.1 to 0.25 may be preferred for some applications, particularly when A is Al. Although a broad variety of different barrier materials may be used, this class has been investigated in particular. Materials in this class may have good structural compatibility and lattice matching with semiconductor materials of Formula 1, e.g. InAs.

The barrier may have a thickness in the range 2 to 30 nm. It is believed that optimum barrier thicknesses are typically within this range, especially for materials of Formula II. For example, the barrier may have a thickness in the range 5 to 10 nm.

One illustrative example device comprises an aluminium superconductor, an InAs semiconductor, a barrier thickness of 5 ± 1 nm, and wherein the barrier comprises a material of Formula II where A is Al and x is 0.25 ± 0.05. In a variant of this example, the semiconductor is a material of Formula I, with y being in the range 0.8 to 1.

Another example device comprises an aluminium superconductor, an InAs semiconductor, a barrier thickness of 10 ± 2 nm, and wherein the barrier comprises a material of Formula II where A is Al and x is 0.15 ± 0.03. In a variant of this example, the semiconductor is a material of Formula I, with y being in the range 0.8 to 1.

Any of the devices provide herein may include a protective dielectric layer, e.g. of an oxide such as hafnium oxide, for protecting one or more parts of the device from water vapour and/or oxygen; and/or for preventing flow of current from the gate electrode to other components of the device, depending on the configuration of the gate electrode.

The semiconductor may be arranged between the barrier and an insulating component. The barrier and the insulating component may comprise the same material.

The insulating component may extend from a surface of a substrate. For example, the first insulating component may be formed integrally with the surface of the substrate. In such configurations the first insulating layer spaces the semiconductor layer away from the surface of the substrate and away from corners wherein the substrate meets the first insulating layer. This may allow for improved reproducibility of the semiconductor layer during manufacturing, because corners and/or substrate surfaces may be difficult to reproduce precisely.

The semiconductor layer may have a thickness in the range 5 nm to 50 nm, optionally 10 to 40 nm, further optionally 20 to 30 nm. Varying the thickness of the semiconductor layer may vary the number of occupied energy levels (sub-bands) at the interface between the semiconductor and the superconductor. This is useful for tuning the quantum mechanical behaviour of the device. Arranging the semiconductor in a sandwich structure between the insulating component and the barrier may allow for precise control over its geometry.

The semiconductor-superconductor hybrid devices provided herein may be configured as nanowires.

The semiconductor-superconductor hybrid devices provided herein further comprises a layer of ferromagnetic insulator configured to apply a magnetic field to the semiconductor and superconductor, e.g. for lifting spin degeneracy. The layer of ferromagnetic insulator may be arranged between the superconductor and the barrier. The ferromagnetic insulator layer may comprise a material selected from: EuS, GdN, Y₃Fe₅O₁₂, Bi₃Fe₅O₁₂, YFeO₃, Fe₂O₃, Fe₃O₄, GdN, Sr₂CrReO₆, CrBr₃/CrI₃, and YTiO₃.

A further aspect provides a quantum computer device comprising the semiconductor-superconductor hybrid device of the present disclosure. Improvements in topological gap are particularly relevant for quantum computing applications. The hybrid device may be useful for generating a qubit.

Another aspect provides the use of a barrier arranged between a semiconductor and a superconductor of a semiconductor-superconductor hybrid device to increase a topological gap of the device.

A still further aspect provides a method of manufacturing the semiconductor-superconductor hybrid device of the present disclosure, comprising: forming the semiconductor; forming the barrier on the semiconductor; and forming the superconductor on the barrier.

The specific techniques used to form the various components may be selected as appropriate. For example, at least one of the first insulating layer, the second insulating layer, and the semiconductor layer may be formed by selective area growth. Selective area growth, and other techniques involving epitaxial crystal growth, allow very close contact between components. In the case of the semiconductor and superconductor, epitaxial growth may allow for improved energy level hybridisation.

The method may further comprise forming any of the various additional components described above with reference to the device.

For example, forming the barrier may comprise epitaxial growth of the barrier; and wherein forming the superconductor comprises epitaxial growth of the superconductor.

Another aspect provides a method of inducing topological behaviour in the semiconductor-superconductor hybrid device of the present disclosure or the quantum computer device of the present disclosure, which method comprises: cooling the semiconductor-superconductor hybrid device to a temperature at which the superconductor is superconductive; applying a magnetic field to the semiconductor-superconductor hybrid device; and applying an electrostatic field to the semiconductor.

The method may comprise inducing an anyon, especially a Majorana zero mode, in the semiconductor-superconductor hybrid device. Without wishing to be bound by theory, a device as provided herein may be capable of generating a Majorana zero mode. The device may be useful in a quantum computer, more particularly a topological quantum computer.

## Claims

1. A semiconductor-superconductor hybrid device, comprising:
a semiconductor (10);
a superconductor (12);
a barrier (14) between the superconductor (12) and the semiconductor (10); wherein the device is configured to enable energy level hybridisation between the semiconductor (10) and the superconductor (12), wherein the barrier (14) is configured to increase a topological gap of the device;
a gate electrode (16) configured to apply an electrostatic field to the semiconductor (10); and
a ferromagnetic insulator layer between the barrier (14) and the superconductor (12).

2. The semiconductor-superconductor hybrid device according to claim 1, further comprising a protective layer (18) arranged between the gate electrode (16) and the semiconductor (10), superconductor (12) and barrier (14) of the device.

3. The semiconductor-superconductor hybrid device according to claim 1 or claim 2, wherein the semiconductor (10) comprises a material of Formula I:
InAs_{y}Sb_{1-y}
where y is in the range 0 to 1; optionally wherein the semiconductor (10) comprises InAs.

4. The semiconductor-superconductor hybrid device according to any preceding claim, wherein the superconductor (12) comprises aluminium.

5. The semiconductor-superconductor hybrid device according to any preceding claim, wherein the barrier (14) comprises a material of Formula II:
In₁₋ₓAₓAs
wherein A is Al or Ga;
wherein x is in the range of 0.05 to 1.

6. The semiconductor-superconductor hybrid device according to claim 5, wherein A is Al.

7. The semiconductor-superconductor hybrid device according to claim 5 or claim 6, wherein x is in the range 0.05 to 0.4, optionally wherein x is in the range of 0.1 to 0.25.

8. The semiconductor-superconductor hybrid device according to any preceding claim, wherein the barrier (14) has a thickness in the range 2 to 30 nm, optionally wherein the barrier (14) has a thickness in the range 5 to 10 nm.

9. The semiconductor-superconductor hybrid device according to any preceding claim, wherein the semiconductor (810) is arranged between the barrier (814) and an insulating component (815), optionally wherein the barrier (814) and the insulating component (815) comprise the same material.

10. The semiconductor-superconductor hybrid device according to any preceding claim, wherein at least a portion of the semiconductor (10) has a thickness in the range 5 to 50 nm.

11. A quantum computer device comprising the semiconductor-superconductor hybrid device according to any preceding claim.

12. Use of a barrier (14) arranged between a semiconductor (10) and a superconductor (12) of a semiconductor-superconductor hybrid device, as defined in any of claims 1 to 10, to increase a topological gap of the device.

13. A method of manufacturing the semiconductor-superconductor hybrid device according to any of claims 1 to 10, comprising:
forming (901) the semiconductor (10);
forming (902) the barrier (14) on the semiconductor (10); and
forming (903) the superconductor (12) on the barrier (14);
optionally wherein forming the barrier (14) comprises epitaxial growth of the barrier (14); and
wherein forming the superconductor (12) comprises epitaxial growth of the superconductor (12).

14. A method of inducing topological behaviour in the semiconductor-superconductor hybrid device according to any of claims 1 to 10 or the quantum computer device according to claim 11, which method comprises:
cooling (1001) the semiconductor-superconductor hybrid device to a temperature at which the superconductor (12) is superconductive;
applying (1002) a magnetic field to the semiconductor-superconductor hybrid device; and
applying (1003) an electrostatic field to the semiconductor (10).

15. The method according to claim 14, wherein the topological behaviour comprises a Majorana zero mode.

## Patentansprüche

1. Halbleiter-Supraleiter-Hybridvorrichtung, umfassend:
einen Halbleiter (10);
einen Supraleiter (12);
eine Barriere (14) zwischen dem Supraleiter (12) und dem Halbleiter (10); wobei die Vorrichtung dazu konfiguriert ist, eine Energieniveauhybridisierung zwischen dem Halbleiter (10) und dem Supraleiter (12) zu ermöglichen, wobei die Barriere (14) dazu konfiguriert ist, eine topologische Lücke der Vorrichtung zu vergrößern;
eine Gate-Elektrode (16), die dazu konfiguriert ist, ein elektrostatisches Feld auf den Halbleiter (10) anzuwenden; und
eine Schicht eines ferromagnetischen Isolators zwischen der Barriere (14) und dem Supraleiter (12).

2. Halbleiter-Supraleiter-Hybridvorrichtung nach Anspruch 1, ferner umfassend eine Schutzschicht (18), die zwischen der Gate-Elektrode (16) und dem Halbleiter (10), dem Supraleiter (12) und der Barriere (14) der Vorrichtung angeordnet ist.

3. Halbleiter-Supraleiter-Hybridvorrichtung nach Anspruch 1 oder Anspruch 2, wobei der Halbleiter (10) ein Material nach Formel I umfasst:
InAs_{y}Sb_{1-y}
wobei y in dem Bereich von 0 bis 1 liegt; optional, wobei der Halbleiter (10) InAs umfasst.

4. Halbleiter-Supraleiter-Hybridvorrichtung nach einem der vorhergehenden Ansprüche, wobei der Supraleiter (12) Aluminium umfasst.

5. Halbleiter-Supraleiter-Hybridvorrichtung nach einem der vorhergehenden Ansprüche, wobei die Barriere (14) ein Material nach Formel II umfasst:
In₁₋ₓAₓAs
wobei A Al oder Ga ist;
wobei x in dem Bereich von 0,05 bis 1 liegt.

6. Halbleiter-Supraleiter-Hybridvorrichtung nach Anspruch 5, wobei A Al ist.

7. Halbleiter-Supraleiter-Hybridvorrichtung nach Anspruch 5 oder Anspruch 6, wobei x in dem Bereich von 0,05 bis 0,4 liegt, optional wobei x in dem Bereich von 0,1 bis 0,25 liegt.

8. Halbleiter-Supraleiter-Hybridvorrichtung nach einem der vorhergehenden Ansprüche, wobei die Barriere (14) eine Dicke in dem Bereich von 2 bis 30 nm aufweist, optional wobei die Barriere (14) eine Dicke in dem Bereich von 5 bis 10 nm aufweist.

9. Halbleiter-Supraleiter-Hybridvorrichtung nach einem der vorhergehenden Ansprüche, wobei der Halbleiter (810) zwischen der Barriere (814) und einer isolierenden Komponente (815) angeordnet ist, optional wobei die Barriere (814) und die isolierende Komponente (815) das gleiche Material umfassen.

10. Halbleiter-Supraleiter-Hybridvorrichtung nach einem der vorhergehenden Ansprüche, wobei mindestens ein Abschnitt des Halbleiters (10) eine Dicke in dem Bereich von 5 bis 50 nm aufweist.

11. Quantencomputervorrichtung umfassend die Halbleiter-Supraleiter-Hybridvorrichtung nach einem der vorhergehenden Ansprüche.

12. Verwendung einer Barriere (14), die zwischen einem Halbleiter (10) und einem Supraleiter (12) einer Halbleiter-Supraleiter-Hybridvorrichtung angeordnet ist, wie in einem der Ansprüche 1 bis 10 definiert, um eine topologische Lücke der Vorrichtung zu vergrößern.

13. Verfahren zum Herstellen der Halbleiter-Supraleiter-Hybridvorrichtung nach einem der Ansprüche 1 bis 10, umfassend:
Bilden (901) des Halbleiters (10);
Bilden (902) der Barriere (14) auf dem Halbleiter (10); und
Bilden (903) des Supraleiters (12) auf der Barriere (14);
optional wobei das Bilden der Barriere (14) ein epitaxiales Wachstum der Barriere (14) umfasst; und
wobei das Bilden des Supraleiters (12) ein epitaxiales Wachstum des Supraleiters (12) umfasst.

14. Verfahren zum Herbeiführen eines topologischen Verhaltens auf der Halbleiter-Supraleiter-Hybridvorrichtung nach einem der Ansprüche 1 bis 10 oder der Quantencomputervorrichtung nach Anspruch 11, wobei das Verfahren Folgendes umfasst:
Kühlen (1001) der Halbleiter-Supraleiter-Hybridvorrichtung auf eine Temperatur, bei der der Supraleiter (12) supraleitend ist;
Anwenden (1002) eines Magnetfelds auf die Halbleiter-Supraleiter-Hybridvorrichtung; und
Anwenden (1003) eines elektrostatischen Feldes auf den Halbleiter (10).

15. Verfahren nach Anspruch 14, wobei das topologische Verhalten einen Majorana-Nullmodus umfasst.

## Revendications

1. Dispositif hybride semi-conducteur-supraconducteur, comprenant :
un semi-conducteur (10) ;
un supraconducteur (12) ;
une barrière (14) entre le supraconducteur (12) et le semi-conducteur (10) ; dans lequel le dispositif est configuré pour permettre une hybridation de niveau d'énergie entre le semi-conducteur (10) et le supraconducteur (12), dans lequel la barrière (14) est configurée pour augmenter une bande interdite topologique du dispositif ;
une électrode de grille (16) configurée pour appliquer un champ électrostatique au semi-conducteur (10) ; et
une couche d'isolant ferromagnétique entre la barrière (14) et le supraconducteur (12).

2. Dispositif hybride semi-conducteur-supraconducteur selon la revendication 1, comprenant en outre une couche de protection (18) disposée entre l'électrode de grille (16) et le semi-conducteur (10), le supraconducteur (12) et la barrière (14) du dispositif.

3. Dispositif hybride semi-conducteur-supraconducteur selon la revendication 1 ou la revendication 2, dans lequel le semi-conducteur (10) comprend un matériau de formule I :
InAs_{y}Sb_{1-y}
où y est situé dans la plage allant de 0 à 1 ; éventuellement dans lequel le semi-conducteur (10) comprend de l'InAs.

4. Dispositif hybride semi-conducteur-supraconducteur selon une quelconque revendication précédente, dans lequel le supraconducteur (12) comprend de l'aluminium.

5. Dispositif hybride semi-conducteur-supraconducteur selon une quelconque revendication précédente, dans lequel la barrière (14) comprend un matériau de formule II :
In₁₋ₓAₓAs
dans lequel A est de l'Al ou du Ga ;
dans lequel x est situé dans la plage allant de 0,05 à 1.

6. Dispositif hybride semi-conducteur-supraconducteur selon la revendication 5, dans lequel A est de l'Al.

7. Dispositif hybride semi-conducteur-supraconducteur selon la revendication 5 ou la revendication 6, dans lequel x est situé dans la plage allant de 0,05 à 0,4, éventuellement dans lequel x est situé dans la plage allant de 0,1 à 0,25.

8. Dispositif hybride semi-conducteur-supraconducteur selon une quelconque revendication précédente, dans lequel la barrière (14) a une épaisseur située dans la plage allant de 2 à 30 nm, éventuellement dans lequel la barrière (14) a une épaisseur située dans la plage entre 5 et 10 nm.

9. Dispositif hybride semi-conducteur-supraconducteur selon une quelconque revendication précédente, dans lequel le semi-conducteur (810) est disposé entre la barrière (814) et un composant isolant (815), éventuellement dans lequel la barrière (814) et le composant isolant (815) comprennent le même matériau.

10. Dispositif hybride semi-conducteur-supraconducteur selon une quelconque revendication précédente, dans lequel au moins une partie du semi-conducteur (10) a une épaisseur située dans la plage entre 5 et 50 nm.

11. Dispositif d'ordinateur quantique comprenant le dispositif hybride semi-conducteur-supraconducteur selon une quelconque revendication précédente.

12. Utilisation d'une barrière (14) disposée entre un semi-conducteur (10) et un supraconducteur (12) d'un dispositif hybride semi-conducteur-supraconducteur tel que défini selon l'une quelconque des revendications 1 à 10 pour augmenter une bande interdite topologique du dispositif.

13. Procédé de fabrication du dispositif hybride semi-conducteur-supraconducteur selon l'une quelconque des revendications 1 à 10, comprenant :
la formation (901) du semi-conducteur (10) ;
la formation (902) de la barrière (14) sur le semi-conducteur (10) ; et
la formation (903) du supraconducteur (12) sur la barrière (14) ;
éventuellement dans lequel la formation de la barrière (14) comprend la croissance épitaxiale de la barrière (14) ; et
dans lequel la formation du supraconducteur (12) comprend la croissance épitaxiale du supraconducteur (12).

14. Procédé d'induction d'un comportement topologique dans le dispositif hybride semi-conducteur-supraconducteur selon l'une quelconque des revendications 1 à 10 ou dispositif d'ordinateur quantique selon la revendication 11, dont le procédé comprend :
le refroidissement (1001) du dispositif hybride semi-conducteur-supraconducteur à une température à laquelle le supraconducteur (12) est supraconducteur ;
l'application (1002) d'un champ magnétique au dispositif hybride semi-conducteur-supraconducteur ; et
l'application (1003) d'un champ électrostatique au semi-conducteur (10).

15. Procédé selon la revendication 14, dans lequel le comportement topologique comprend un mode zéro Majorana.
